# FASCICULE DE BREVET EUROPEEN

(11) **EP 1 157 460 B1**
(45) Date de publication et mention de la délivrance du brevet: **05.11.2003**
(21) Numéro de dépôt: 00905118.6
(22) Date de dépôt: 11.02.2000
(51) Int. Cl.: H03H 9/05

(54) **DISPOSITIF A ONDES DE SURFACE CONNECTE A UNE EMBASE AVEC UN ADHESIF CONDUCTEUR**
AKUSTISCHE OBERFLÄCHENWELLENANORDNUNG VERBUNDEN MIT EINEM SOCKEL DURCH EINEN LEITENDEN KLEBSTOFF
SURFACE WAVE DEVICE CONNECTED TO A BASE WITH CONDUCTIVE ADHESIVE

(30) Priorité: 12.02.1999 FR 9901722
(43) Date de publication de la demande: 28.11.2001
(73) Titulaire: Thales, 75008 Paris (FR)
(72) Inventeur: NGUYEN, Ngoc-Tuan, Thomson-CSF P.I. Dépt. Brevets, 94117 Arcueil Cedex (FR); BUREAU, Jean-Marc, Thomson-CSF P.I. Dépt. Brevets, 94117 Arcueil Cedex (FR); LELONG, Christian, Thomson-CSF P.I. Dépt. Brevets, 94117 Arcueil Cedex (FR)
(86) Numéro de dépôt international: FR0000347
(87) Numéro de publication internationale: WO00048313

(56) Documents cités:
- EP-A- 0 840 369
- EP-A- 0 896 427
- US-A- 5 939 817
- KISHIMOTO Y ET AL: "Anisotropic conductive paste available for flip chip" PROCEEDINGS OF 3RD INTERNATIONAL CONFERENCE ON ADHESIVE JOINING AND COATING TECHNOLOGY IN ELECTRONICS MANUFACTURING 1998 (CAT. NO.98EX180), PROCEEDINGS OF 3RD INTERNATIONAL CONFERENCE ON ADHESIVE JOINING AND COATING TECHNOLOGY IN ELECTRONICS MANUFACT, pages 137-143, XP002119762 1998, New York, NY, USA, IEEE, USA ISBN: 0-7803-4934-2
- KAZUO ISHIBASHI ET AL.: "A New Anisotropic Conductive Film with Arrayed Conductive Particles" IEEE TRANSACTIONS ON COMPONENTS, PACKAGING AND MANUFACTURING TECHNOLOGY. PART B: ADVANCED PACKAGING., vol. 19, no. 4, novembre 1996 (1996-11), pages 752-757, XP002119763 IEEE SERVICE CENTER, PISCATAWAY, NJ., US ISSN: 1070-9894
- LIU J: "Recent advances in conductive adhesives for direct chip attach applications" PROCEEDINGS. THE FIRST IEEE INTERNATIONAL SYMPOSIUM ON POLYMERIC ELECTRONICS PACKAGING, PEP '97 (CAT. NO.97TH8268), PROCEEDINGS. THE FIRST IEEE INTERNATIONAL SYMPOSIUM ON POLYMERIC ELECTRONICS PACKAGING, PEP '97 (CAT. NO.97TH8268), NORRKOPING, SWEDEN, pages 107-122, XP002119764 1997, New York, NY, USA, IEEE, USA ISBN: 0-7803-3865-0
- KEN GILLEO: "Direct Chip Interconnect Using Polymer Bonding" IEEE TRANSACTIONS ON COMPONENTS,HYBRIDS,AND MANUFACTURING TECHNOLOGY., vol. 13, no. 1, mars 1990 (1990-03), pages 229-234, XP002119765 IEEE INC. NEW YORK., US ISSN: 0148-6411

## Description

Le domaine de l'invention est celui des composants à ondes de surface utilisés dans le domaine électronique, notamment comme filtres RF ou IF dans le but de sélectionner des bandes de fréquences.

Ces composants utilisent le principe de propagation acoustique des ondes de surface, à la surface d'un substrat piézo-électrique. Pour assurer une propagation des ondes acoustiques de surface satisfaisante, la surface du composant doit être protégée contre toutes pollutions et toutes sollicitations mécaniques.

Par ailleurs, comme les ondes acoustiques se propagent à la surface du substrat piézo-électrique, cette surface doit être laissée libre pour ne pas perturber la propagation des ondes, ce qui constitue une contrainte supplémentaire au niveau des boîtiers d'encapsulation.

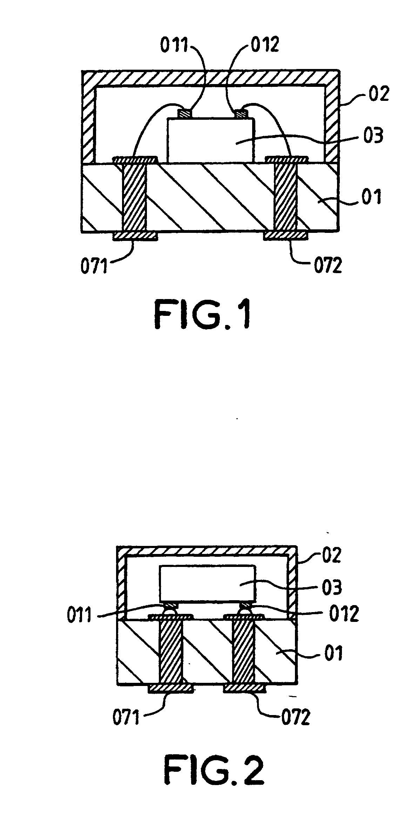

Les technologies actuelles d'encapsulation des filtres à ondes de surface reposent sur un boîtier en deux parties, comme illustrée en Figure 1 : une embase céramique ou organique 01, et un couvercle céramique, métallique ou organique 02, dont la fermeture par soudure ou par collage assure l'herméticité du composant tout en ménageant la cavité nécessaire. Dans ce type de boîtiers, les dispositifs à ondes de surface (DOS) 03, peuvent être assemblés par collage sur l'embase. Les connexions électriques entre les plots internes 011, 012 du DOS et des plots externes 071 et 072 sont assurées par des vias métallisés au travers de l'embase 01.

La Figure 1 illustre un exemple de l'art antérieur, dans lequel les connexions électriques du DOS avec l'extérieur sont de type fil. Pour assurer une meilleure compacité, la technique de type point (« flip chip »), (le composant étant retourné) est actuellement employée. La Figure 2 illustre un exemple de DOS encapsulé selon l'art connu, qui constitue une variante de la Figure 1. La méthode de type flip-chip est développée en détail dans le brevet US 5252 882. Le DOS est reporté face active vers l'embase par l'intermédiaire de billes appelées « Bumps » métalliques qui assure à la fois la connexion électrique entre le DOS et l'embase et la tenue mécanique de cet assemblage. Cependant, le nombre limité et la petite taille de ces billes limitent la tenue mécanique de l'assemblage.

C'est pourquoi certains ont proposé d'utiliser une résine d'encapsulation pour renforcer la tenue mécanique de ces billes qui assurent les connexions électriques entre le DOS et l'embase. De telles résines sont notamment décrites dans le brevet européen EP 0896 427 A2.

Dans ce contexte, l'invention propose un nouveau composant à ondes de surface comprenant un DOS monté face active vers une embase et assemblé à ladite embase à l'aide d'un adhésif conducteur anisotrope.

L'adhésif conducteur anisotrope assure avantageusement une fonction de connexion électrique.

Plus précisément l'invention a pour objet un composant à ondes de surface encapsulé comprenant :
- un dispositif à ondes de surface à la surface d'un substrat piézo-électrique dite surface active, ledit dispositif comportant des électrodes interdigitées reliées à des bus conducteurs ;
- une embase comportant des électrodes reliées à des plots conducteurs externes ;
caractérisé en ce que : la surface active du dispositif à ondes de surface est assemblée à l'embase par l'intermédiaire d'un adhésif conducteur anisotrope selon un axe Z perpendiculaire au plan du dispositif à ondes de surface, au niveau des bus conducteurs en regard des électrodes de l'embase de manière à assurer des connexions électriques.

Selon une variante de l'invention, l'adhésif conducteur anisotrope peut également être situé sur l'ensemble de la périphérie du dispositif à ondes de surface de manière à réaliser l'encapsulation dudit dispositif.

Les électrodes de l'embase ont une structure adaptée pour comprimer localement l'adhésif conducteur anisotrope, condition nécessaire pour écraser les particules conductrices. Selon l'invention, il n'est donc pas nécessaire de réaliser des bumps sur l'embase ou sur le DOS. Cette structure comporte une succession de surépaisseurs locales permettant la compression locale, pouvant être de l'ordre de quelques dizaines de microns.

Selon une variante préférentielle de l'invention, l'adhésif conducteur anisotrope est un matériau composite comportant des particules conductrices et un matériau liant.

Selon une variante de l'invention les électrodes de l'embase constituent des barrières contre le fluage de l'adhésif conducteur anisotrope vers les zones actives du dispositif à ondes de surface. Avantageusement ces électrodes peuvent être en forme de peigne dont les dents sont perpendiculaires à la direction de propagation des ondes acoustiques du dispositif à ondes de surface.

L'invention sera mieux comprise et d'autres avantages apparaîtront à la lecture de la description qui va suivre, donnée à titre non limitatif et grâce aux figures annexées, parmi lesquelles :
- Les Figures 1 et 2 illustrent des dispositifs à ondes de surface, encapsulés selon des techniques de l'art connu.
- La Figure 3 illustre le processus d'assemblage utilisé dans l'invention. La Figure 3a montre le matériau conducteur anisotrope au repos entre deux électrodes, la Figure 3b montre le matériau conducteur anisotrope en compression entre deux électrodes.
- La figure 4 illustre un exemple de dispositif à ondes de surface comprenant deux transducteurs.
- Les Figure 5a à 5c illustrent des exemples d'embase pouvant être utilisées dans l'invention.
- La Figure 6 illustre un exemple de matériau conducteur anisotrope superposé à un dispositif à ondes acoustiques de surface.
- La Figure 7 illustre un exemple de dispositif encapsulé selon l'invention.
- La Figure 8 illustre un exemple de dispositif selon l'invention, encapsulé dans un boîtier standard.

De manière générale, le composant de l'invention comprend un dispositif à ondes de surface qui a la particularité d'être monté face active vers une embase et assemblé à cette embase, via un adhésif conducteur anisotrope qui assure à la fois une fonction électrique et une fonction mécanique. Le même adhésif peut assurer également une fonction d'absorbant acoustique.

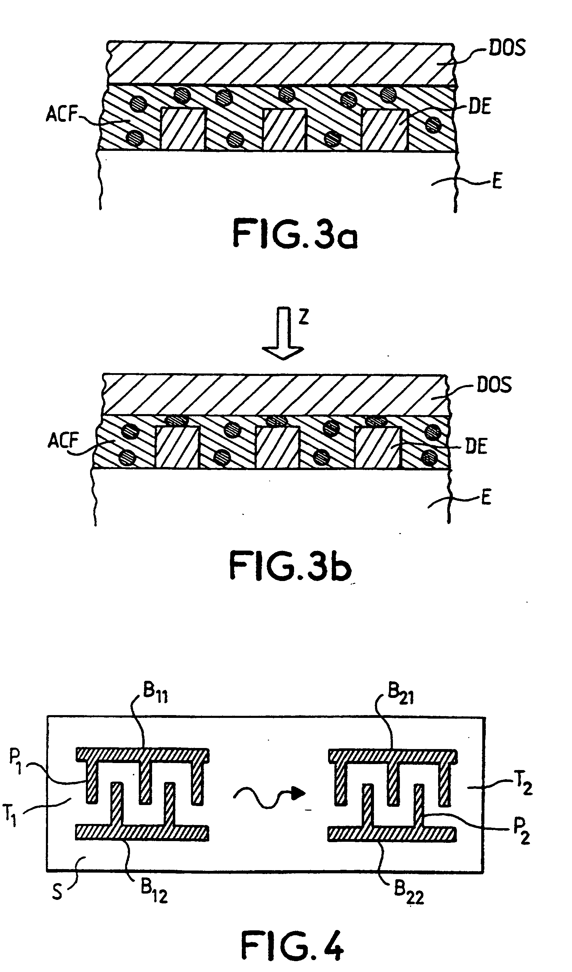

Le matériau adhésif conducteur anisotrope présente la propriété d'être conducteur dans une direction privilégiée, comme l'illustre la Figure 3 qui schématise un film d'adhésif conducteur constitué d'un matériau liant et de particules conductrices. Typiquement, ce matériau inséré entre deux électrodes, puis pressé à chaud est en mesure d'assurer le contact électrique, uniquement selon la direction Z. La Figure 3a montre le film ACF au repos, la Figure 3b illustre l'opération de pressage à chaud qui permet d'assurer le contact électrique entre les deux électrodes. Plus précisément ces figures illustrent une variante dans laquelle l'embase E comporte des électrodes en forme de peignes dont les dents DE sont représentées en coupe, en regard de l'électrode du DOS.

La conductivité électrique est réalisée par écrasement des particules dans l'axe z, correspondant à l'axe de conduction, lors du report par pression entre les deux surfaces à assembler.

Dans le cadre de l'invention, une des électrodes, correspond à celle du dispositif à ondes acoustiques de surface, l'autre électrode peut avoir été réalisée à la surface de l'embase, comme cela sera décrit plus en détail ultérieurement.

Pour assurer l'anisotropie recherchée du matériau liant les deux surfaces conductrices à connecter, on peut avantageusement utiliser un polymère thermodurcissable ou thermoplastique chargé avec des particules polymères métallisées par notamment un dépôt d'or ou de nickel. La taille des particules peut varier entre quelques microns et une vingtaine de microns. La densité des particules peut typiquement être de l'ordre de 1000 billes/mm² à 15000 billes/mm².

Dans le cadre de l'invention, le matériau conducteur anisotrope permet de lier le dispositif à ondes acoustiques à une embase.

De manière plus détaillée, nous allons décrire un exemple de dispositif à ondes acoustiques de surface, réalisé à la surface d'un substrat piézo-électrique de type quartz, tantalate de lithium, sur lequel sont réalisées par évaporation sous vide, les peignes d'électrodes interdigitées qui constituent la surface active génératrice d'ondes acoustiques, et des bus généralement en aluminium qui permettent d'alimenter électriquement les peignes. Un exemple d'un tel dispositif est illustré en Figure 4. Deux transducteurs T₁ et T₂ sont réalisés à la surface du substrat piézo-électrique, chacun comporte respectivement deux bus B₁₁, B₁₂, B₂₁, B₂₂ et des peignes d'électrodes P₁ et P₂. La face arrière du dispositif à ondes de surface peut être striée pour absorber les ondes de volume.

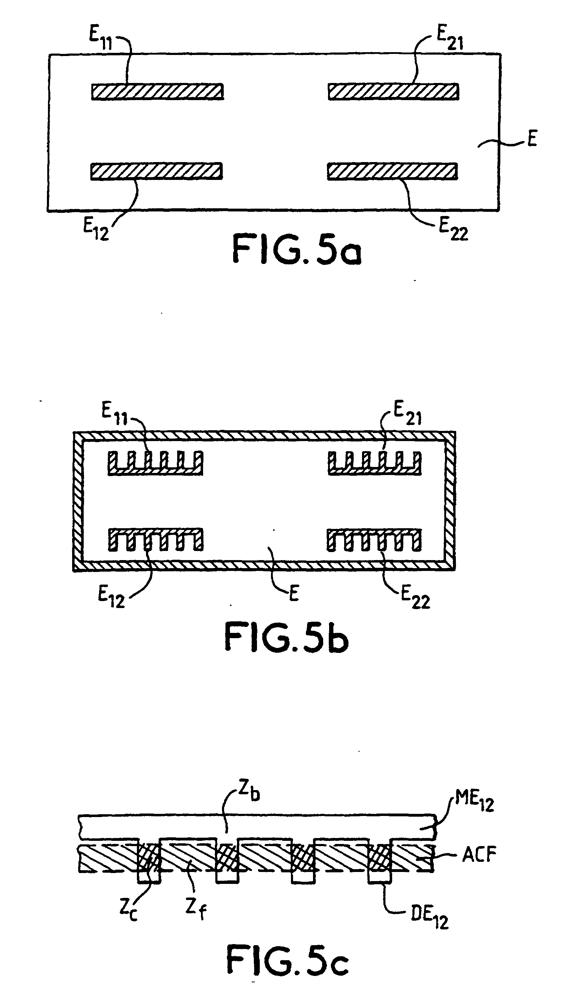

L'embase E est représentée en Figure 5a. Elle comporte sur l'une de ses faces des électrodes E₁₁, E₁₂, E₂₁, E₂₂ destinées à assurer le contact des bus B₁₁, B₁₂, B₂₁, B₂₂ des transducteurs T₁ et T₂ précédemment décrits, sur l'autre face non représentée des plots conducteurs permettent d'assurer le contact électrique avec l'extérieur, il peut s'agir par exemple d'un circuit imprimé à connecter au dispositif à ondes de surface. Des vias conducteurs réalisés au travers de l'embase assurent la liaison électrique entre les électrodes E₁₁, E₁₂, E₂₁, E₂₂ et les plots conducteurs externes. Dans cette technologie, l'embase peut être réalisée en céramique (Al₂ O₃) ou en polymère chargé (par exemple de la résine époxy-verre) ou bien encore en film polyimide (par exemple du Kapton).

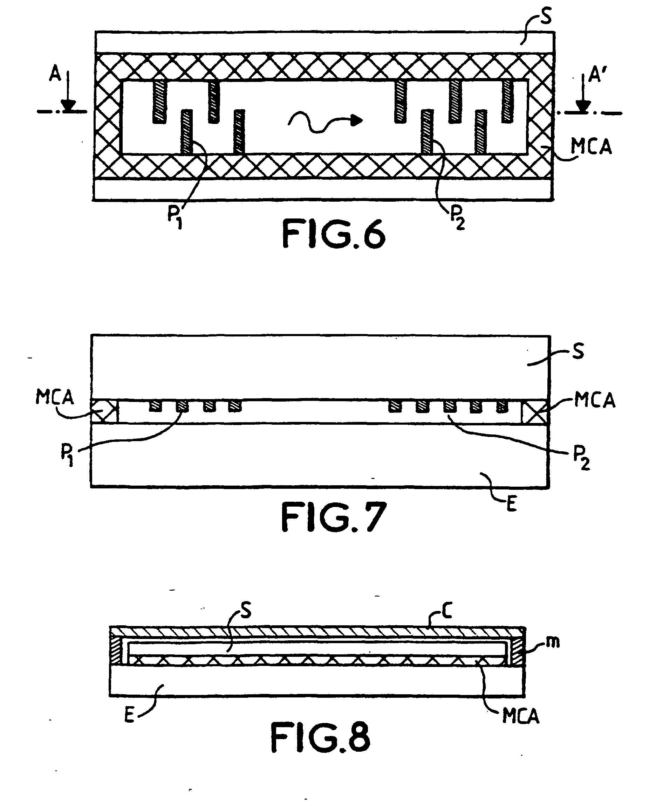

Le matériau conducteur anisotrope a pour fonction d'assembler mécaniquement et de connecter électriquement le dispositif à ondes acoustiques à l'embase. Pour ce faire, le matériau conducteur anisotrope (MCA), peut aussi bien être déposé côté embase ou côté dispositif. Lorsque l'on choisit un film de MCA, on peut notamment utiliser une préforme prédécoupée mécaniquement, par laser ou par toute autre méthode. Lorsque l'on choisit une pâte, on peut réaliser un dépôt par sérigraphie, dépôt à la seringue. On peut également procéder à un dépôt couvrant toute la surface du substrat ou de l'embase puis localisé par gravure chimique, mécanique ou par ablation laser de manière à dégager l'espace libre nécessaire à la propagation des ondes de surface. Dans tous les cas, le dépôt du matériau est effectué au niveau des plages de connexions électriques en regard (bus/électrodes de l'embase), mais le caractère anisotrope du matériau conducteur, permet le dépôt sur des surfaces plus étendues que celles à connecter, sans court-circuiter les plages conductrices indépendantes, situées dans un même plan. Le matériau peut notamment, avantageusement être localisé dans les endroits suivants :
- Sur les surfaces non actives du dispositif à ondes de surface, afin de renforcer la tenue mécanique de l'assemblage en augmentant la surface de collage et en répartissant les contraintes mécaniques.
- Sur des zones spécifiques du dispositif à ondes de surface, afin d'absorber les ondes acoustiques de surface si nécessaire (il peut typiquement s'agir de supprimer des réflexions des bords du dispositif, suppression du couplage acoustique entre différentes zones actives).
- Sur l'ensemble de la périphérie d'un dispositif à ondes de surface, pour en assurer l'étanchéité comme illustré en Figure 6.

Par ailleurs, pour assurer une épaisseur calibrée de matériau anisotrope conducteur, et calibrer la hauteur de la cavité ainsi définie, il est possible d'utiliser des billes métalliques (appelées bumps) déposées côté dispositif à ondes de surface.

Il est également possible de réaliser des structures en relief côté dispositif ou côté embase pour comprimer localement l'adhésif conducteur anisotrope, pour contrôler le fluage du matériau conducteur anisotrope et en particulier empêcher sa migration vers les surfaces actives du dispositif. Il s'agit d'électrodes sous forme de peigne, comme l'illustre la Figure 5b. En effet lors de la réalisation de l'assemblage embase substrat on dispose avantageusement le conducteur anisotrope sur les doigts des peignes d'électrodes. Sous l'effet de la pression et de la température, le fluage du conducteur anisotrope est arrêté par les barrières que constituent les électrodes et plus particulièrement le manche des peignes, comme l'illustre la Figure 5c. Les dents DE₁₂ ont une structure constituée de surépaisseurs permettant de comprimer localement l'adhésif dans les zones Z_{c}. Selon l'invention il n'est donc pas nécessaire de réaliser des bumps sur l'embase ou sur le DOS. Les zones Z_{f} représentent des zones de fluage vis-à-vis de l'adhésif conducteur non comprimé. Les zones Z_{b} constituées par le manche du peigne constituent des zones barrière au fluage de l'adhésif conducteur anisotrope ACF vers les régions actives.

Lorsque les motifs désirés sont réalisés au niveau du matériau conducteur anisotrope, on procède à l'assemblage des trois éléments dispositif / matériau conducteur / embase. Cette opération est effectuée à une température et à une pression qui sont déterminées en fonction de la nature du matériau conducteur anisotrope. Typiquement, la pression nécessaire pour obtenir le collage et l'établissement du contact électrique varie entre 10 et 30 bars et la température varie entre 150° C et 220° C.

Dans l'exemple cité ci-dessus, le matériau conducteur anisotrope assure également une fonction d'étanchéité qui permet de concevoir un dispositif à ondes acoustiques de surface, particulièrement compact, puisque ne présentant aucune place perdue comme le met en évidence la Figure 7 qui illustre le dispositif de la Figure 6 assemblé à une embase, dans un plan de coupe AA'.

Pour des applications dans lesquelles les contraintes d'étanchéité et de robustesse sont très fortes, l'assemblage illustré en Figure 7, peut tout aussi bien être intégré dans un boîtier d'encapsulation standard comme le schématise la figure 8, le matériau MCA assure toujours la connexion électrique entre l'embase et le dispositif à ondes acoustiques de surface. Des murets m et un couvercle C constitue la partie supérieure du boitier d'encapsulation.

## Revendications

1. Composant à ondes de surface encapsulé comprenant :
- un dispositif à ondes de surface (DOS) à la surface d'un substrat piézo-électrique dite surface active, ledit dispositif comportant des électrodes interdigitées reliées à des bus conducteurs ;
- une embase (E) comportant des électrodes reliées à des plots conducteurs externes ;
**caractérisé en ce que** : la surface active du dispositif à ondes de surface est assemblée à l'embase par l'intermédiaire d'un adhésif conducteur anisotrope selon un axe Z perpendiculaire au plan du dispositif à ondes de surface, au niveau des bus conducteurs en regard des électrodes de l'embase de manière à assurer des connexions électriques, les électrodes de l'embase ayant des structures en relief constituant des barrières contre le fluage de l'adhésif conducteur anisotrope vers les zones actives du dispositif à ondes de surface, avec des surépaisseurs locales (Z_{c}) permettant de comprimer localement l'adhésif conducteur anisotrope (ACF).

2. Composant à ondes de surface selon la revendication 1, **caractérisé en ce que** les électrodes de l'embase ont une architecture en forme de peigne présentant un manche (ME₁₂) et des dents (DE₁₂), lesdites dents étant perpendiculaires à la direction de propagation des ondes acoustiques du dispositif à ondes de surface.

3. Composant à ondes de surface selon la revendication 2, **caractérisé en ce que** l'adhésif conducteur anisotrope est déposé au niveau des dents du peigne (DE₁₂).

4. Composant à ondes de surface selon l'une des revendications 1 à 3 **caractérisé en ce que** les surépaisseurs sont de l'ordre de quelques dizaines de microns.

5. Composant à ondes de surface selon l'une des revendications 1 à 4, **caractérisé en ce que** l'adhésif conducteur anisotrope est un matériau composite comportant des particules conductrices et un matériau liant.

6. Composant à ondes de surface selon la revendication 5, **caractérisé en ce que** le matériau liant est un polymère thermodurcissable ou thermoplastique.

7. Composant à ondes de surface selon l'une des revendications 5 ou 6, **caractérisé en ce que** les particules conductrices sont des particules de polymères métallisées.

8. Composant à ondes de surface selon l'une des revendications 5 ou 6, **caractérisé en ce que** les particules conductrices sont des particules métalliques.

9. Composant à ondes de surface selon l'une des revendications 5 à 9, **caractérisé en ce que** les particules ont un diamètre compris entre environ quelques microns et une vingtaine de microns.

10. Composant à ondes de surface selon l'une des revendications 1 à 9, **caractérisé en ce que** l'adhésif conducteur anisotrope possède des propriétés d'absorbant acoustique.

11. Composant à ondes de surface selon l'une des revendications 1 à 10, **caractérisé en ce que** l'adhésif anisotrope conducteur est également situé sur l'ensemble de la périphérie du dispositif à ondes de surface de manière à réaliser l'encapsulation dudit dispositif.

## Patentansprüche

1. Gekapseltes Oberflächenwellenbauelement, mit:
- einer Oberflächenwellenvorrichtung (DOS) auf der Oberfläche eines piezoelektrischen Substrats, die aktive Oberfläche genannt wird, wobei die Vorrichtung interdigitale Elektroden aufweist, die mit Leiterbussen verbunden sind;
- einer Basis (E), die Elektroden aufweist, die mit externen Leiterkontakten verbunden sind;
**dadurch gekennzeichnet, dass**:
die aktive Oberfläche der Oberflächenwellenvorrichtung mit der Basis über einen leitenden, anisotropen Klebstoff längs einer zu der Ebene der Oberflächenwellenvorrichtung senkrechten Z-Achse auf Höhe der Leiterbusse gegenüber den Elektroden der Basis in der Weise zusammengefügt ist, dass elektrische Verbindungen sichergestellt sind, wobei die Elektroden der Basis Reliefstrukturen besitzen, die gegenüber einem Kriechen des anisotropen leitenden Klebstoffs in die aktiven Zonen der Oberflächenwellenvorrichtung Sperren bilden, wobei lokale Überdicken (Z_{c}) ermöglichen, den anisotropen leitenden Klebstoff (ACF) lokal zu komprimieren.

2. Oberflächenwellenbauelement nach Anspruch 1, **dadurch gekennzeichnet, dass** die Elektroden der Basis eine kammförmige Architektur besitzen, die einen Stiel (MO₁₂) und Zähne (DE₁₂) aufweist, wobei die Zähne zur Ausbreitungsrichtung der Schallwellen der Oberflächenwellenvorrichtung senkrecht sind.

3. Oberflächenwellenbauelement nach Anspruch 2, **dadurch gekennzeichnet, dass** der anisotrope leitende Klebstoff auf Höhe der Zähne (DE₁₂) des Kamms abgelagert ist.

4. Oberflächenwellenbauelement nach einem der Ansprüche 1 bis 3, **dadurch gekennzeichnet, dass** die Überdicken in der Größenordnung von einigen 10 Mikrometern liegen.

5. Oberflächenwellenbauelement nach einem der Ansprüche 1 bis 4, **dadurch gekennzeichnet, dass** der anisotrope leitende Klebstoff ein Verbundwerkstoff ist, der leitende Partikel und ein Bindemittel enthält.

6. Oberflächenwellenbauelement nach Anspruch 5, **dadurch gekennzeichnet, dass** das Bindemittel ein wärmeaushärtendes oder thermoplastisches Polymer ist.

7. Oberflächenwellenbauelement nach einem der Ansprüche 5 oder 6, **dadurch gekennzeichnet, dass** die leitenden Partikel Partikel aus metallisierten Polymeren sind.

8. Oberflächenwellenbauelement nach einem der Ansprüche 5 oder 6, **dadurch gekennzeichnet, dass** die leitenden Partikel metallische Partikel sind.

9. Oberflächenwellenbauelement nach einem der Ansprüche 5 bis 9, **dadurch gekennzeichnet, dass** die Partikel einen Durchmesser besitzen, der im Bereich von einigen Mikrometern bis etwa 20 Mikrometern liegt.

10. Oberflächenwellenbauelement nach einem der Ansprüche 1 bis 9, **dadurch gekennzeichnet, dass** der anisotrope leitende Klebstoff schallabsorbierende Eigenschaften besitzt.

11. Oberflächenwellenbauelement nach einem der Ansprüche 1 bis 10, **dadurch gekennzeichnet, dass** sich der anisotrope leitende Klebstoff außerdem auf dem gesamten Umfang der Oberflächenwellenvorrichtung befindet, um so die Kapselung der Vorrichtung zu schaffen.

## Claims

1. Encapsulated surface wave component comprising:
- a surface wave device (SWD) on the surface of a piezoelectric substrate, the so-called active surface, the said device comprising interdigital electrodes linked to conducting buses;
- a base (E) comprising electrodes linked to external conducting pads;
**characterized in that**: the active surface of the surface wave device is assembled to the base by way of a conductive adhesive which is anisotropic along an axis Z perpendicular to the plane of the surface wave device, at the level of the conducting buses opposite the electrodes of the base in such a way as to provide for electrical connections, the electrodes of the base having structures in relief constituting barriers against the creeping of the anisotropic conductive adhesive towards the active zones of the surface wave device, with local thickenings (Z_{c}) making it possible to compress the anisotropic conductive adhesive (ACF) locally.

2. Surface wave component according to Claim 1, **characterized in that** the electrodes of the base have an architecture in the form of a comb exhibiting a haft (ME₁₂) and teeth (DE₁₂), the said teeth being perpendicular to the direction of propagation of the acoustic waves of the surface wave device.

3. Surface wave component according to Claim 2, **characterized in that** the anisotropic conductive adhesive is deposited at the level of the teeth of the comb (DE₁₂).

4. Surface wave component according to one of Claims 1 to 3, **characterized in that** the thickenings are of the order of a few tens of microns.

5. Surface wave component according to one of Claims 1 to 4, **characterized in that** the anisotropic conductive adhesive is a composite material comprising conducting particles and a binder material.

6. Surface wave component according to Claim 5, **characterized in that** the binder material is a thermosetting or thermoplastic polymer.

7. Surface wave component according to either of Claims 5 and 6, **characterized in that** the conducting particles are metallized polymer particles.

8. Surface wave component according to either of Claims 5 and 6, **characterized in that** the conducting particles are metal particles.

9. Surface wave component according to one of Claims 5 to 9, **characterized in that** the particles have a diameter of between around a few microns and about twenty microns.

10. Surface wave component according to one of Claims 1 to 9, **characterized in that** the anisotropic conductive adhesive possesses acoustic absorbent properties.

11. Surface wave component according to one of Claims 1 to 10, **characterized in that** the conducting anisotropic adhesive is also situated on the entire periphery of the surface wave device in such a way as to achieve the encapsulation of the said device.
